# EUROPÄISCHE PATENTANMELDUNG

(11) **EP 0 809 425 A1**
(43) Veröffentlichungstag der Anmeldung: **26.11.1997**
(21) Anmeldenummer: 96810331.7
(22) Anmeldetag: 23.05.1996
(51) Int. Cl.: H05K 7/14, H05K 9/00

(54) **Baugruppenträger mit Frontplatte**

(71) Anmelder: ELMA Electronic AG, 8620 Wetzikon (CH)
(72) Erfinder: Scheibler, Eduard, 8620 Wetzikon (CH)
(74) Vertreter: Heubeck, Bernhard

(57) **Zusammenfassung**

Mit der Erfindung sind Baugruppenträger für elektromagnetisch abgeschirmte Steckbaugruppen gezeigt, welche eine Frontplatte (2) tragen, die ihrerseits U-förmige Schenkel (3, 3', 4, 4') mit seitlichen Federelementen (5) zur Abschirmung aufweist. Durch die Verwendung eines passenden metallischen Blechs und eine darauf abgestimmte geometrische Gestaltung von Schenkeln (3, 4) und Federelementen (6, 17) können Abschirmplatte (10, 10'), Schenkel (3, 4) und Federelemente (6, 17) einstückig aus dem Blech geschnitten und gebogen werden. Wenn man sich für standardisierte Schenkel (3, 4) und Federelemente (6, 17) mit entsprechenden Biegewerkzeugen entscheiden kann und das Ausschneiden beispielsweise NC-gesteuert mit Laser an einem rostfreien Blech vornimmt, entsteht eine hohe Flexibilität für unterschiedliche Abmessungen von Frontplatten (2) und auch bei kleinen Losgrössen eine rationelle Fertigung.

## Beschreibung

Die Erfindung handelt von einem Baugruppenträger für elektromagnetisch abgeschirmte Steckbaugruppen, welche zur Frontseite eine Frontplatte tragen, die ihrerseits U-förmige Schenkel aufweist, um mit Federelementen den seitlichen Kontakt zu benachbarten Frontplatten mit U-förmigen Schenkein aufrecht zu erhalten.

Beim deutschen Gebrauchsmuster G 88 03 544.1 sind auf den seitlichen Schenkeln von Frontplatten Federblechstreifen am ersten Schenkel einer Frontplatte mittels einer Halteplatte oder direkt befestigt, um auf der Seite des mit dem Federblech besetzten Schenkels Kontakt zum freien Schenkel einer Nachbarfrontplatte zu machen. Eine solche Anordnung hat den Nachteil, dass sie einen relativ hohen Montageaufwand benötigt und enge Toleranzen zwischen Frontplattenseitenmassen und den zu befestigenden Federelementen erfordert. Im weiteren besteht der Nachteil, dass im Gehäuse Federelemente für die angrenzenden federlosen Schenkel von Frontplatten vorgesehen werden müssen oder zusätzliche Frontplatten mit beidseitig federbesetzten Schenkein vorzusehen sind.

Die vorliegende Erfindung hat die Aufgabe, auf einfache Art die seitliche Abschirmung einer Frontplatte vorzunehmen. Diese Aufgabe wird mit den Kennzeichen vom unabhängigen Anspruch 1 dadurch erreicht, dass Frontplatten als Abschirmplatten mit U-förmig nach innen gebogenen Schenkein und auf jedem Schenkel mit Federelementen einstückig aus einem metallischen Blech geschnitten und gebogen sind.

Diese Ausführung hat den Vorteil, dass eine universelle Schenkelform und -abdichtung für verschieden breite Frontplatten mit dem Werkzeugsatz für einen Schenkel herstellbar ist und dass die Wiederholgenauigkeit der Frontplatten gross ist. Vorteilhafte Weiterbildungen der Erfindung sind in den abhängigen Ansprüchen 2 bis 11 aufgezeigt. Durch die Verwendung von dünnen, federnden metallischen Blechen, wie zum Beispiel Stahlblechen, können die für den Kontaktdruck notwendigen Federelemente als Blattfedern freigeschnitten werden, während die Kontaktpunkte seitlich aus dem Profil der Schenkel vorstehen. Die Kontaktpunkte können dabei durch vorstehende Ausstülpungen als Noppen gebildet werden. Dadurch, dass die Noppen in einer Schräge oder konisch zum Kontaktpunkt hin ansteigen, fährt beim Einfahren der Frontplatte zunächst die Schräge auf der Gegenseite auf, über die das Federelement zur Erzeugung der notwendigen Kontaktkraft vorgespannt wird, wenn der Kontaktpunkt in seine Endstellung fährt.

Durch den Höhenversatz der Kontaktpunkte zwischen dem linken und rechten Schenkel einer Abschirmplatte kann trotz dem Freischneiden von Blattfedern eine relativ grosse Dichte von Kontaktpunkten zwischen zwei benachbarten Abschirmplatten erzeugt werden. Im weiteren können die gleichen Werkzeuge für die Bearbeitung vom linken und rechten Schenkel verwendet werden, wenn diese über einen Punkt der Mittellinie der Abschirmplatte zueinander punktgespiegelt sind. Wenn die Abschirmplatten seitlich sehr dicht zueinander stehen, kann der Deformationsweg für einen Kontaktpunkt durch einen Einlauf an dem Schenkel der Nachbarabschirmplatte erzeugt werden. Da bei benachbarten Abschirmplatten jede der beiden relativ zur anderen bereits befestigten Abschirmplatte einschiebbar sein soll, ist es sinnvoll zu einem Einlauf auf der Vorderseite einen Einlauf auf der Innenseite vorzusehen, um so von der Montagereihenfolge unabhängig zu sein. In einem solchen Fall werden ähnliche Aufschiebkräfte erreicht, wenn die Kontaktpunkte etwa in der Mitte der Tiefe eines Schenkels angeordnet sind und wenn die Neigung des Einlaufs von innen und von aussen gleich ist. Dies könnte bei einem Schenkel geringer Tiefe zu einer zu kurzen Blattfeder führen, wenn diese mit ihrer Achse in der Einschieberichtung angeordnet ist. Abhilfe schaffen hier Blattfedern deren Achsen quer zur Einschieberichtung angeordnet sind oder Blattfedern, die als doppelt eingespannte Torsionsfedern quer zur Einschieberichtung fortgesetzt sind. Bei der Anwendung von Laserschnitttechnik ist es sogar möglich, Blattfedern durch einen spiralförmigen Schnitt freizuschneiden. Mit wachsendem Abstand vom Zentrum der spiralförmigen Biegefeder mit dem Kontaktpunkt wächst dann die Torsionskraft im Federarm. Durch eine entsprechende Wahl der Spirale kann die Feder zum Zentrum hin weicher konzipiert werden. Bei sehr eng stehenden Abschirmplatten können die Einläufe auch der Grobzentrierung in der Höhe dienen. Eine Möglichkeit besteht darin, die vollständige Abschirmplatte aus einem rostfreien Stahlband zu stanzen. Da solche, für Werkzeuge verwendeten Bänder relativ geringe Wandstärke aufweisen, kann es durchaus sinnvoll sein, auf der Frontseite der Abschirmplatten zusätzliche Platten oder Beläge mit Beschriftungen oder mit einem Dekor aufzubringen. Diese Beläge müssen nicht notwendigerweise aus Metall sein. Es sind auch Kunststoffplatten oder -beläge denkbar.

Zur Herstellung der beschriebenen Geometrie können konventionelle Stanz- und Umformwerkzeuge verwendet werden. Gerade jedoch bei dünnen rostfreien Stahlblechen ist die Laserschnitt-Technik heute soweit entwickelt, dass das Ausschneiden von Abschirmplatte mit Aussparungen in einer Zeit von wenigen Minuten durch einen Laser in Kombination mit einem digital ansteuerbaren Kreuztisch möglich ist, während die Biegeoperationen und die plastische Umformung für Seitenschenkel und Noppen in konventioneller Umformtechnik ausgeführt werden. Kleine Losgrössen und sogar Einzelanfertigungen sind bei einer Aufteilung auf standardisierte Seitenschenkel, deren Biege- und Verformoperationen mit Stanz- und Umformwerkzeugen geschehen, und auf unterschiedlich breit mit Laser ausgeschnittene Abschirmplatten möglich.

Im folgenden wird die Erfindung von einem Ausführungsbeispiel beschrieben. Es zeigen:
- Fig. 1: Schematisch zwei benachbarte in einer Frontalebene liegende Abschirmplatten die seitlich auseinander bewegt sind;
- Fig. 2 und 3: schematisch verschiedene Ausführungsformen für Seitenschenkel mit Blattfedern, und
- Fig. 4: schematisch einen Noppen mit Blattfeder und seitlich davon wegbewegt einen Einlauf von aussen und einen Einlauf von innen.

Mit den Figuren sind Baugruppenträger für elektromagnetisch abgeschirmte Steckbaugruppen gezeigt, welche eine Frontplatte 2 tragen, die ihrerseits U-förmige Schenkel 3, 3', 4, 4' mit seitlichen Federelementen 5 zur Abschirmung aufweist. Durch die Verwendung eines passenden metallischen Blechs und eine darauf abgestimmte geometrische Gestaltung von Schenkeln 3, 4 und Federelementen 6, 17 können Abschirmplatte 10, 10', Schenkel 3, 4 und Federelemente 6, 17 einstückig aus dem Blech geschnitten und gebogen werden. Wenn man sich für standardisierte Schenkel 3, 4 und Federelemente 6, 17 mit entsprechenden Biegewerkzeugen entscheiden kann und das Ausschneiden beispielsweise NC-gesteuert mit Laser an einem rostfreien Blech vornimmt, entsteht eine hohe Flexibilität für unterschiedliche Abmessungen von Frontplatten 2 und auch bei kleinen Losgrössen eine rationelle Fertigung.

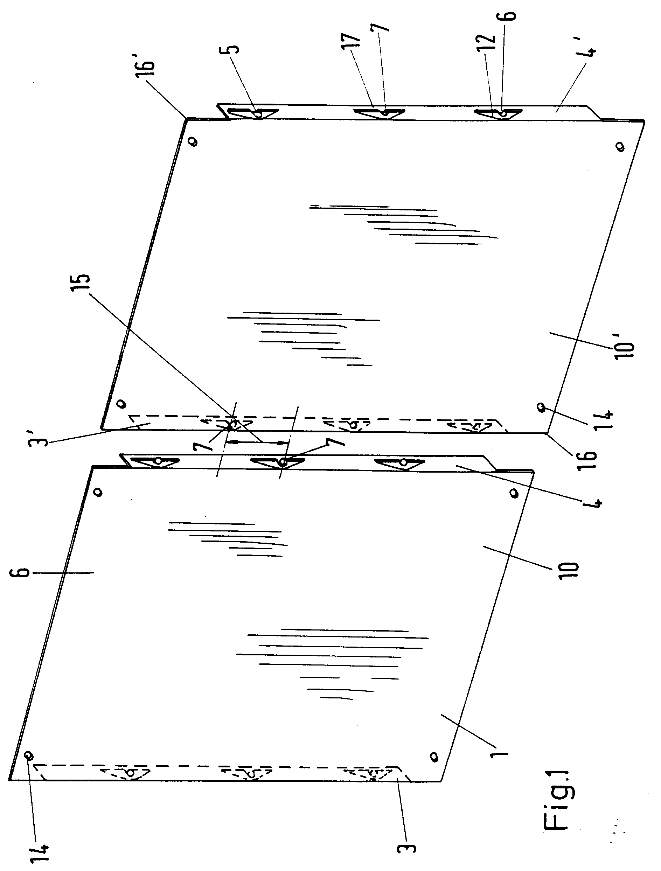

In Figur 1 sind zwei Abschirmplatten 10, 10' aus einem rostfreien Blech ausgeschnitten worden und mit Fenstern 12 versehen worden, um Federelemente 5 in Form von Blattfedern 6 mit einem Torsionsfederteil 17 freizuschneiden. Die eigentlichen Kontaktpunkte 7 am Ende der Blattfedern 6 sind als über das seitliche Profil vorstehende Noppen ausgebildet. Auf der Frontseite sind sichtbar Befestigungsbohrungen 14 angebracht, um die rückseitig mit Steckbaugruppen (hier nicht gezeigt) verbundenen Abschirmplatten 10, 10' mit einem Gehäuse (ebenfalls nicht gezeigt) zu verbinden. Um die von den Federelementen 5 an den Frontplatten auftretenden Seitenkräfte aufzufangen, sind die Steckbaugruppen (hier nicht gezeigt) mit den Frontplatten zum Gehäuse hin mit Positionierstiften versehen, welche beim Einfahren von Steckbaugruppe mit Frontplatte in entsprechenden Bohrungen auf der Gehäuseseite geführt sind. Die Biegeoperation zum Ausstülpen der Noppen und zum Umklappen der Schenkel 3, 3', 4, 4' wurde mit Umformwerkzeugen gemacht. Die linken Schenkel 3, 3' sind mit ihren Aussparungen und Federelementen 5 punktgespiegelt zu den rechten Schenkeln 4, 4'. Dabei sind die Kontaktpunkte 7 so verteilt, dass bei zwei nebeneinander liegenden Abschirmplatten 10, 10' die Kontaktpunkte 7 wechselseitig einen Versatz 15 zueinander aufweisen. Dies bedeutet jedoch nicht, dass auch die eine Diagonale bildenden Ecken 16, 16' einer Abschirmplatte 10' über den gleichen Punkt zueinander gespiegelt sein müssen. Für die Befestigung zwischen Abschirmplatten 10, 10' und ihren zugehörigen Steckbaugruppen sind beispielsweise Nietverbindungen, Schraubverbindungen, Punktschweissen oder Klebeverbindungen möglich. Insbesondere rostfreie Bleche lassen sich problemlos Punktschweissen.

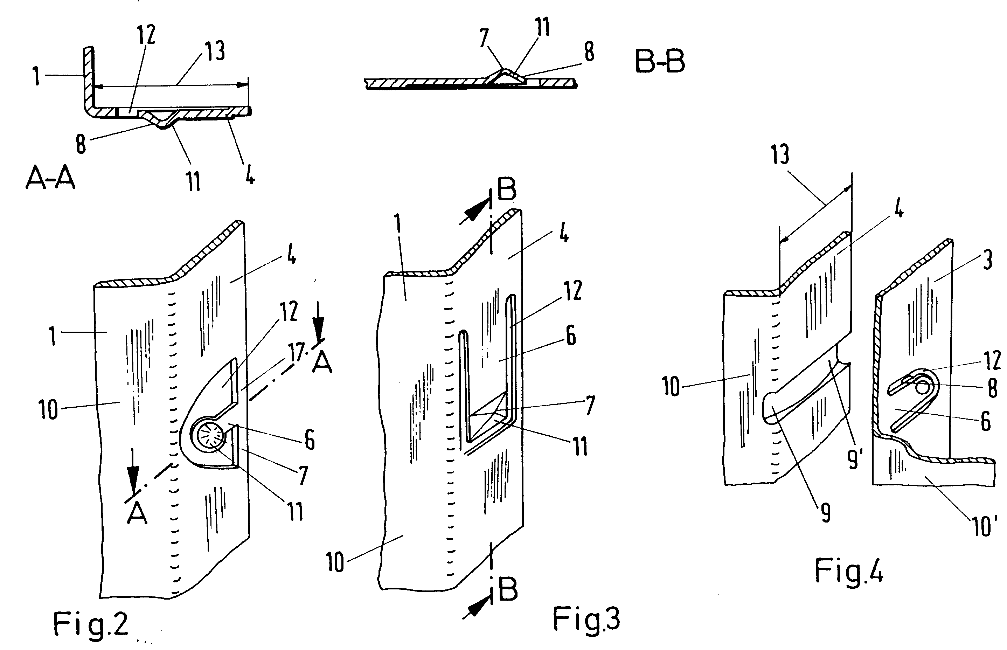

In Figur 2 ist der Uebergang an einer Abschirmplatte 10 von der Frontseite 1 auf den rechten Schenkel 4, in welchem ein Fenster 12 derart ausgeschnitten ist, dass ein beispielsweise vorher gestanzter Noppen 8 mit einem Kontaktpunkt 7 auf einem Federelement in Form von einer Blattfeder 6 in Einschubrichtung, welche durch eine zweiseitig eingespannte Torsionsfeder 17 fortgesetzt ist, stehen bleibt. Diese Anordnung hat den Vorteil, dass trotz des kurzen Federarms der Blattfeder 6 durch die Fortsetzung als Torsionsfeder ein relativ langer Federweg entsteht, auf dem keine plastische Verformung stattfindet. Mit diesem Torsionsfederanteil 17 ist es möglich, die Tiefe 13 vom Seitenschenkel sehr gering zu halten. Der vorstehende Noppen 8 ist so in seiner Höhe angepasst, dass mit seinem Verschwinden im Profil des Schenkels 4 noch kein Ueberspannen des Federelementes eintritt. Der Noppen 8 besitzt schräge oder konische Flächen 11, mit denen er bei einer Relativbewegung in Einschubrichtung bei einer Nachbarabschirmplatte oder an einer Gehäusegrenzung auffährt, um eine notwendige Kontaktkraft zu erzeugen. Bei einer Ausführung des Noppens 8 als Kugelkalotte entsteht eine gleichmässigere Verteilung der Einschubkraft, da unter geringer Federvorspannung zunächst die steileren Partien auflaufen, während die Schräge bei höherer Federspannung kleiner wird.

In Figur 3 ist ein Schenkel 4 mit einer Biegefeder 6 gezeigt, bei dem die Achse der Biegefeder quer zur Einschubrichtung liegt. Der Noppen 8 ist pyramidenförmig ausgeführt.

In Figur 4 ist eine an einem Schenkel 3 einseitig eingespannte kurze Biegefeder 6 gezeigt, die auf der Gegenseite an einem Schenkel mit einem zweiseitigen Einlauf 9, 9' auffahren kann, um eine notwendige Kontaktkraft zu erzeugen. In diesem Fall ist die Zunahme der Kontaktkraft von der Schräge des Einlaufs abhängig. Auch hier ist es für eine unabhängige Montagereihenfolge vorteilhaft, wenn der Kontaktpunkt vom Noppen 8 in seiner Endstellung in etwa in der Mitte der Tiefe des Gegenschenkels 4 liegt.

Ganz allgemein bestimmt die ausgewählte Dicke des Metallblechs und dessen Elastizitätsgrenze, welche Konstruktion der einstückig ausgeformten Federelemente in Frage kommt, um Schwankungen in den Montagetoleranzen aufzufangen. Bei sehr dünnen Metallblechen wie z.B. Federblechen ist es denkbar, die Abschirmplatten 10, 10' mindestens auf einem Teil der Frontseite 1 mit einer Abdeckung, die nicht metallisch zu sein braucht, zu versteifen, indem man sie zwischen Abdeckung und Steckbaugruppe über Zuganker wie beispielsweise Schrauben einspannt. An und für sich tritt bereits durch die Befestigung der Abschirmplatten an den Steckbaugruppen eine genügende Versteifung der Frontseite ein. In der vertikalen Richtung der Abschirmplatten 10, 10' wird eine Versteifung schon durch die abgebogenen Schenkel 3, 4, 3', 4' erreicht, während in der Querrichtung dazu durch horizontal verlaufende Sicken die Steifigkeit vergrössert werden kann. Nach innen geformte Sicken erleichtern beispielsweise bei rostfreien Blechen auch das Punktschweissen für eine Befestigung.

## Patentansprüche

1. Baugruppenträger für elektromagnetisch abgeschirmte Steckbaugruppen, welche zur Frontseite (1) hin eine Frontplatte (2) tragen, die ihrerseits U-förmige Schenkel (3, 4) aufweist, um mit Federelementen (5) den seitlichen Kontakt zu benachbarten Frontplatten (2) mit U-förmigen Schenkeln (3', 4') aufrecht zu erhalten, dadurch gekennzeichnet, dass die Frontplatten als Abschirmplatten (10, 10') mit U-förmig nach innen gebogenen Schenkeln (3, 4) und auf jedem Schenkel mit Federelementen (5) einstückig aus einem metallischen Blech geschnitten und gebogen sind.

2. Baugruppenträger nach Anspruch 1, dadurch gekennzeichnet, dass in nach innen gebogenen Schenkeln (3, 4) als Federelemente (5) Blattfedern (6, 17) mit Kontaktpunkten (7) freigeschnitten sind, wobei die Kontaktpunkte (7) seitlich aus dem Profil der Schenkel (4, 5) vorstehen.

3. Baugruppenträger nach Anspruch 2, dadurch gekennzeichnet, dass die Kontaktpunkte (7) der Federelemente (5) aus vorstehenden Noppen (8) bestehen.

4. Baugruppenträger nach einem der Ansprüche 1 bis 3, dadurch gekennzeichnet, dass die Kontaktpunkte (7) der Federelemente (5, 6) in den linken und rechten Schenkeln (3, 4) zueinander in der Höhe versetzt sind, um auf jeder Seite zu einer benachbarten Abschirmplatte (10') oder auch zu einer Gehäusebegrenzung Kontakt herstellen zu können.

5. Baugruppenträger nach Anspruch 4, dadurch gekennzeichnet, dass die linken und rechten Schenkel (3, 4) der Abschirmplatten (10) jeweils auf der Höhe der Kontaktpunkte (7) der Nachbarabschirmplatten (10') einen Einlauf (9) aufweisen, um beim Einschieben einer Steckbaugruppen eine vorgesehene Kontaktkraft an den Federelementen (5, 6) zu erzeugen.

6. Baugruppenträger nach Anspruch 5, dadurch gekennzeichnet, dass die Einläufe (9) trichterförmig ausgebildet sind, damit beim Einschieben der Steckbaugruppen über die Einläufe (9) und Kontaktpunkte (7) auch eine gegenseitige Grobausrichtung in der Höhe der Abschirmplatten (10, 10') stattfindet.

7. Baugruppenträger nach Anspruch 5 oder 6, dadurch gekennzeichnet, dass Kontaktpunkte (7) auf die Tiefe (13) der Schenkel (3, 4) bezogen in etwa in der Mitte eines Schenkels angeordnet sind und dass auf den gegenüberliegenden Schenkeln (3', 4') pro Kontaktpunkt ein Einlauf (9) von aussen und ein Einlauf (9') von innen vorgesehen ist, um unabhängig von der relativen Einschiebebewegung zwischen zwei Frontplatten (2) eine mit der Einschiebebewegung stetig wachsende Kontaktkraft zu erzeugen.

8. Baugruppenträger nach Anspruch 3, dadurch gekennzeichnet, dass die Noppen (8) eine ausgeprägte konische oder geneigte Fläche (11) aufweisen, die beim Einschieben einer Steckbaugruppe mit Abschirmplatte (10) vor dem eigentlichen Kontaktpunkt auf dem Schenkel (3', 4') einer benachbarten Abschirmplatte (10') auffährt, um das Federelement (5, 6) bis zur Endstellung des Kontaktpunktes (7) vorzuspannen.

9. Baugruppenträger nach einem der Ansprüche 1 bis 8, dadurch gekennzeichnet, dass an der Frontseite (1) der Abschirmplatten (10, 10') zusätzliche Platten mit Beschriftungen oder Dekor befestigt sind.

10. Baugruppenträger nach einem der Ansprüche 1 bis 9, dadurch gekennzeichnet, dass die Abschirmplatten (10, 10') an der Frontseite (1) horizontale Sicken zur Versteifung aufweisen.

11. Baugruppenträger nach Anspruch 2, dadurch gekennzeichnet, dass die Blattfedern als Biegefedern mit einem Torsionsfederanteil (17) ausgebildet sind.
